# EUROPÄISCHE PATENTANMELDUNG

(11) **EP 1 672 377 A1**
(43) Veröffentlichungstag der Anmeldung: **21.06.2006**
(21) Anmeldenummer: 05025139.6
(22) Anmeldetag: 17.11.2005
(51) Int. Cl.: G01R 33/561

(54) **Wirbelstromkompensation mit N-Average SSFP Bildgebung**

(30) Priorität: 15.12.2004 DE 102004060768
(71) Anmelder: Universitätsklinikum Freiburg, 79106 Freiburg (DE)
(72) Erfinder: Markl, Michael, Dr., 79108 Freiburg (DE); Leupold, Jochen, 79114 Freiburg (DE)
(74) Vertreter: Kohler Schmid Möbus

(57) **Zusammenfassung**

Ein Verfahren nach der Technik eines Steady State Free Precession (SSFP) - Gradientenecho-Verfahrens, insbesondere der Kernspin(=NMR)tomographie, bei welchem eine regelmäßige Folge von Hochfrequenzpulsen mit Flipwinkel α im zeitlich konstanten Abstand TR angewendet wird, wobei die Phase dieser Pulse in aufeinander folgenden Schritten um ein konstantes Phaseninkrement erhöht wird ist dadurch gekennzeichnet, dass ein vorgegebenes Phasenkodierschema so durchgeführt wird, dass jeder einzelne Phasenkodierschritt N mal identisch wiederholt wird und dabei folgende Bedingungen gelten:
- N geradzahlig und N ≥ 2;
- aufeinander folgende gemessene NMR-Signale werden gemittelt.

Hierdurch können die infolge der Inkrementierung von Phasekodiergradienten entstehenden Artefakte minimiert werden.

## Beschreibung

Die Erfindung betrifft ein Verfahren nach der Technik eines Steady State Free Precession (SSFP) - Gradientenecho-Verfahrens, insbesondere der Kernspin-(=NMR)tomographie, bei welchem eine regelmäßige Folge von Hochfrequenzpulsen mit Flipwinkel α im zeitlich konstanten Abstand TR angewendet wird, wobei die Phase dieser Pulse in aufeinander folgenden Schritten um ein konstantes Phaseninkrement erhöht wird.

### SSFP Bildgebung

Die Erzeugung eines SSFP-Signals erfolgt durch eine kontinuierliche Folge von Hochfrequenzpulsen und wurde von Carr bereits 1958 eingeführt [1]. Carr konnte zeigen, dass eine Implementierung des Verfahrens mit äquidistanten Hochfrequenzpulsen mit konstanter Amplitude und alternierender Phase zu einer besonders hohen Signalintensität des SSFP-Signals von On-Resonanz Spins führt.

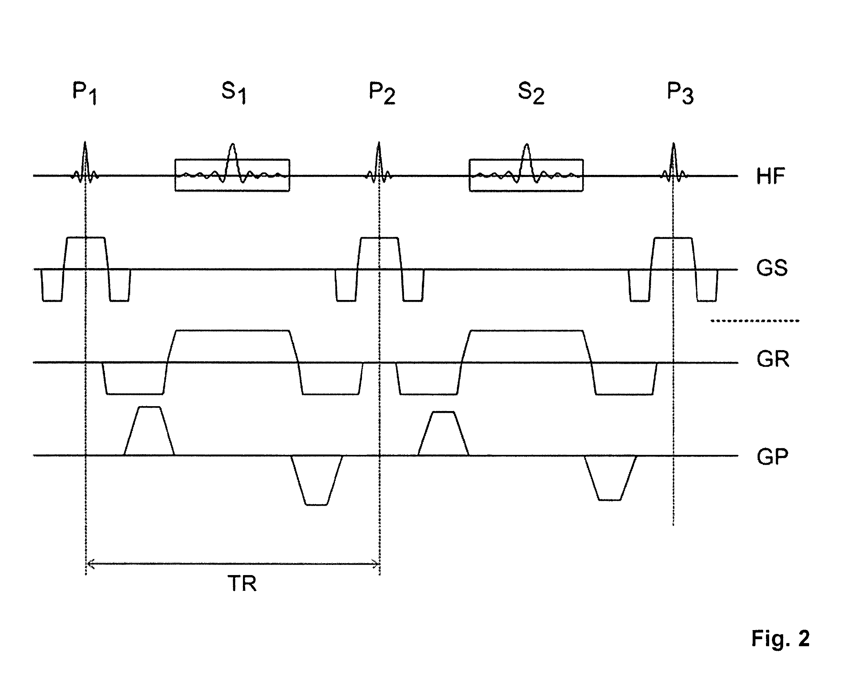

Dieses Prinzip wurde 1986 in Form des FISP-Verfahrens (inzwischen TrueFISP genannt) in ein Verfahren der MR-Bildgebung umgesetzt [2]. Alle Gradienten sind so geschaltet, dass deren Integral vom Zentrum eines Pulses bis zum Zentrum des nächsten Pulses gleich Null ist. Aufeinanderfolgende Pulse haben Flipwinkel α und alternierende Phasen: P1, P3, P5 ...= α, P2, P4, P6 ..= -α. Der zeitliche Abstand zwischen 2 Pulsen wird als Wiederholzeit TR bezeichnet (siehe Fig. 2).

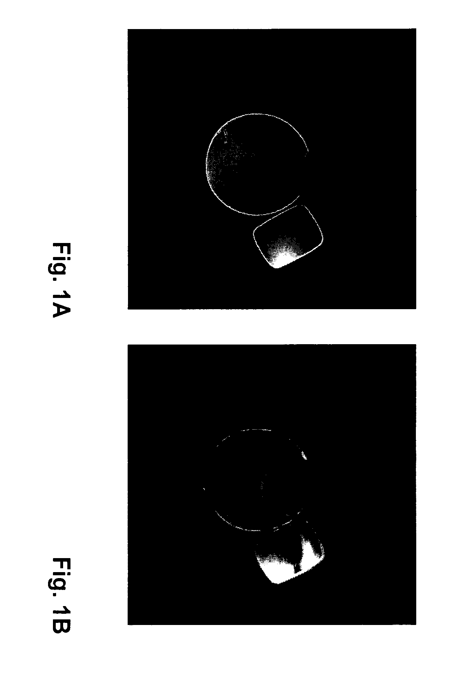

Ein Problem bei der Implementierung stellt dabei die Tatsache dar, dass die zur Bilderzeugung nötige Inkrementierung von Phasenkodiergradienten zu zeitlich veränderlichen Wirbelstromeffekten und damit Signalfluktuationen führen können. Insbesondere bei SSFP Anwendungen mit nicht linearer Datenerfassung (k-Raum Abtastung) und daher hohen Amplitudensprüngen benachbarter Phasenkodierschritte, führt diese Sensitivität von SSFP Bildgebung gegenüber Wirbelstromeffekten zu starken Artefakten im MRT Bild (siehe Fig. 1) [3,4].

### Wirbelstromunterdrückung

Eine Unterdrückung dieser wirbelstrominduzierten Signalfluktuationen gelingt dadurch, dass die k-Raum Abtastung so angepasst wird, dass vor jedem größeren k-Raum Sprung ein direkt benachbarter Phasenkodierschritt ausgelesen wird ("Paired Phase Encoding") [5].

Eine Erklärung der Unterdrückung der Signalmodulation folgt aus Tatsache, dass das SSFP Signal durch die Entstehung einer dualen Steady State Konfiguration bestimmt wird. Dabei wird eine bestimmte Anordnung der signalerzeugenden Magnetisierung in aufeinander folgenden HF-Anregungen aufeinander abgebildet. Durch Veränderung der Gradientenamplituden zur Phasenkodierung in sukzessiven HF-Anregungen wird eine Änderung der von Wirbelströmen induzierten MRT-Signalphase bewirkt, die dazu führen kann, dass das Aufeinanderabbilden der dualen Steady State Magnetisierungskonfigurationen gestört wird. Diese Konfigurationsstörung führt dann zur Auflösung des SSFP Steady State und damit zu Signalfluktuationen und Bildartefakten.

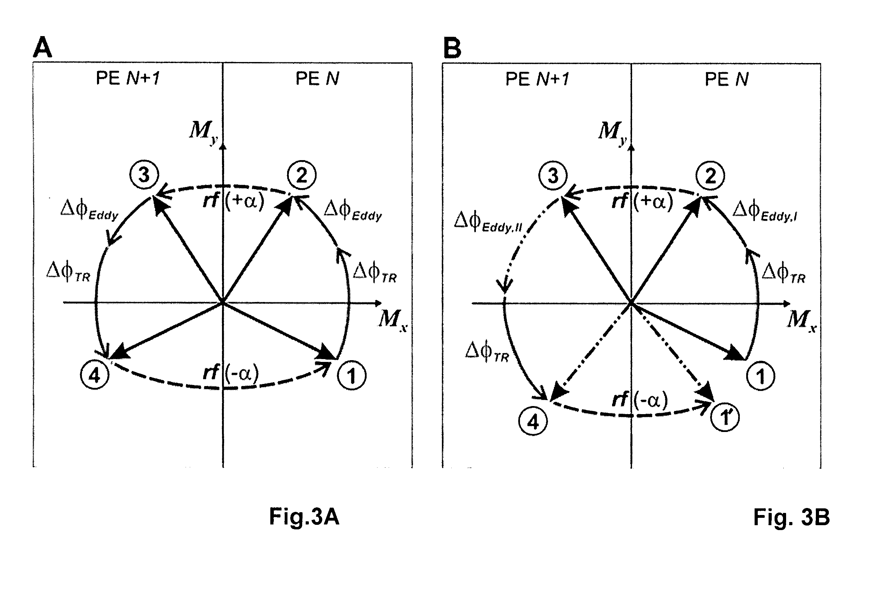

Diese Entstehung von Bildartefakten und Störung der dualen Steady State Konfiguration bei Verwendung inkrementeller Phasenkodierung ist auch in Fig. 3B dargestellt. Fig. 3B zeigt die zeitliche Entwicklung der transversalen Komponente des MRT Magnetisierungsvektors im Steady State für zwei aufeinander folgende Datenakquisitionsintervalle ((1)->(2) und (3)->(4)) und HF-Anregungen mit Flipwinkel α (rf(+α) und rf (-α)). Die zeitliche Entwicklung des MRT-Signals und damit verbundene potentielle Signaloszillationen sind durch die zeitliche Entwicklung von Lage und Betrag des Magnetisierungsvektors bestimmt. Die transversale Magnetisierung wird durch unterschiedliche Phasenkodierschritte und damit verschiedenen wirbelstrominduzierter Signalphasen (Δφ_{*Eddy*,*I*} und Δφ_{*Eddy,II*}) nach zwei Datenakquisitionsintervallen und HF-Anregungen nicht wieder auf sich selbst abgebildet ((4)->(1') statt (1)). Die duale Konfiguration des SSFP Steady State wird dadurch gestört und es kommt zu Signalfluktuationen und Bildartefakten.

Bei der "Paired Phase Encoding" Aufnahmestrategie werden Gradientenunterschiede der Phasenkodierung paarweise so klein wie möglich gehalten, so dass paarweise keine oder nur minimale Unterschiede bei den von Wirbelströmen induzierten Signalphasen auftreten. Im Ergebnis bedeutet dies, dass eine beliebige Wirbelstromphase während der darauf folgenden Anregung wieder ganz oder teilweise kompensiert werden kann.

Eine Datenaufnahme mit "Paired Phase Encoding" führt demnach zu einer Reduktion von Wirbelstromartefakten, erlaubt aber keine vollständige Kompensation, da die paarweise aufeinander folgenden Phasenkodierschritte noch einen kleinen Gradientenamplitudenunterschied aufweisen und demnach zu unterschiedlichen von Wirbelströmen induzierten Signalphasen führen können (siehe auch Fig. 3B).

Die besten Ergebnisse werden für so genannte On-resonance Spins erzielt, welche während TR keinerlei zusätzliche Phasenänderung erfahren. Es zeigt sich aber, dass die Wirbelstromsensitivität, d.h. die unvollständige Kompensation von Wirbelstromeffekten, der Methode mit der lokalen Off-Resonanz-Frequenz, d.h. der Feldinhomogenität, im zu untersuchenden Gewebe zunimmt.

Bei Anwendungen in der MRT ist diese Bedingung allerdings selbst für sehr kleine Wiederholzeiten TR nicht erfüllt, wobei das kürzeste erreichbare TR im Wesentlichen durch die Schaltgeschwindigkeiten der Magnetfeldgradienten bestimmt wird. Durch Magnetfeldinhomogenitäten erfahren Spins eine gewisse Dephasierung um einen Phasenwinkel Δφ zwischen zwei Anregungen. Für TR=4 ms ist Δφ =90° für eine Off-Resonanz Frequenz ΔΩ von Δφ /(TR* 360°)= 66 Hz. Dies entspricht bei einer Resonanzfrequenz von 63 MHz bei 1,5 Tesla Feldstärke einer Inhomogenität von 1 ppm. Solche Inhomogenitäten sind bei Anwendungen am Menschen wegen der dort auftretenden Suszeptibilitätseffekte und lokalen Variationen der chemischen Verschiebung nicht vermeidbar.

Weitere, für das erfindungsgemäße Verfahren relevante MR-Methoden beziehen sich auf die Beschleunigung der MRT-Bildgebung mit Paralleler Bildgebung [6,7] sowie auf die Unterbrechung des SSFP Steady State mittels 'Steady State Storage' [8]. Letzteres stellt eine Methode dar, die es erlaubt, Präparationssequenzen (z.B. zur Fettsättigung) so in eine SSFP Messung einzufügen, dass Artefakte aufgrund der Unterbrechung des Steady State reduziert werden. Allerdings werden auch für diese Methode die besten Ergebnisse für so genannte On-Resonanz Spins erzielt, womit die Artefaktsensitivität, d.h. nichtidealer 'Steady State Storage', mit der lokalen Off-Resonanz, d.h. mit der Feldinhomogenität, im zu untersuchenden Gewebe zunimmt.

Aufgabe der Erfindung ist es, ein Verfahren vorzuschlagen, das die infolge der Inkrementierung von Phasekodiergradienten entstehenden Artefakte minimiert.

### Optimierte Wirbelstromkompensation (N-Average SSFP Bildgebung)

Diese Aufgabe wird erfindungsgemäß dadurch gelöst, dass ein vorgegebenes Phasenkodierschema so durchgeführt wird, dass jeder einzelne Phasenkodierschritt N mal identisch wiederholt wird und dabei folgende Bedingungen gelten:
- N geradzahlig und N ≥ 2, also (N=2, 4, 6, 8,...);
- aufeinander folgende gemessene NMR-Signale werden gemittelt.

Bei dem erfindungsgemäßen Verfahren wird bei einer Steady State-Sequenz mit Flipwinkeln α und alternierender Phase die k-Raum Abtastung, d.h. die zeitliche Abfolge aufeinander folgender Phasenkodierschritte so abgeändert, dass eine optimale Kompensation von Wirbelstromeffekten erreicht wird, wobei bei der bevorzugten Implementierung folgende Merkmale erfüllt werden:

Ein vorgegebenes Phasenkodierschema wird so durchgeführt, dass jeder einzelne Phasenkodierschritt N mal identisch wiederholt wird und die dabei gemessenen MR-Signal gemittelt werden, wobei N gerade und größer oder gleich zwei sein muss ((N-Average SSFP Bildgebung, N=2,4,6,8,....).

Im einfachsten Fall werden die einzelnen Phasenkodierschritte jeweils doppelt aufgenommen (N=2, Double Average SSFP Bildgebung) so dass eine ideale Wirbelstromkompensation bei einer Verdopplung der Gesamtmesszeit erreicht wird.

Das Verfahren ist unabhängig von der Vorgeschichte der Phasenkodierung und kann auf beliebige Phasenkodierschemata angewandt werden

Die Funktionsweise im Falle idealer Wirbelstromkorrektur ist auch in Fig. 3A für den Fall N=2 (Double Average SSFP Bildgebung) illustriert. Fig. 3A zeigt die zeitliche Entwicklung der transversalen Komponente des MRT Magnetisierungsvektors im Steady State für zwei aufeinander folgende Datenakquisitionsintervalle ((1)->(2) und (3)->(4)) und HF-Anregungen mit Flipwinkel α (rf(+α) und rf (-α)). Die zeitliche Entwicklung des MRT-Signals und damit verbundene potentielle Signaloszillationen sind durch die zeitliche Entwicklung von Lage und Betrag des Magnetisierungsvektors bestimmt. Die paarweise Aufnahme identischer Phasenkodieramplituden führt zur Reproduktion identischer durch Wirbelströme induzierte Signalphasen (Δφ_{*Eddy*}) in aufeinander folgenden Datenakquisitionsintervallen. Diese addieren sich übereinstimmend zu den zeitlich konstanten Signalphasen aus Off-Resonanzen (*Δφ*_{*TR*}) in beiden Konfigurationen des dualen Steady State, so dass die dualen Magnetisierungskonfigurationen trotz Wirbelstromeffekten identisch ineinander übergeführt werden. Die duale Konfiguration des SSFP Steady State bleibt erhalten und Signalfluktuationen, d.h. Bildartefakte, werden weitgehend vermieden. Die Signalmittelung führt zusätzlich zu einer Glättung bei eventuell auftretenden Signaloszillationen sukzessiver Phasenkodierschritte.

Wird im nächsten Schritt ein anderer Phasenkodiergradient gewählt, so kann die durch nun veränderte Wirbelströme induzierte Signalphase wieder durch wiederholte Akquisition mit identischer Phasenkodieramplitude kompensiert werden.

Das Verfahren lässt sich auch mit anderen bildgebenden Methoden, die auf SSFP Bildgebung beruhen, verbinden. Die Phasenkodierung kann dabei neben der häufig angewendeten zwei-dimensionalen Fouriertransformation auch in einem dreidimensionalen Phasenkodierverfahren erfolgen. Auch Mehrschichtaufnahmen durch sequentielle Anregung paralleler Schichten können zur Erzielung von Bildern entsprechenden Kontrastes realisiert werden.

Das erfindungsgemäße Verfahren kann auch auf Verfahren übertragen werden, bei welchen eine Bildkodierung nach anderen Methoden wie etwa der gefilterten Rückprojektion (Backprojection) erfolgt. Dabei erfolgt eine Anwendung von Magnetfeldgradienten entsprechend einer Bildkodierung nach dem Verfahren der gefilterten Rückprojektion.

### Ideale Wirbelstromkompensation & parallele SSFP Bildgebung

Bei einer bevorzugten Variante des erfindungsgemäßen Verfahrens werden zusätzlich zu der Folge von Hochfrequenzpulsen Magnetfeldgradienten zur Kodierung eines NMR-Bildes entsprechend einem zwei- oder auch mehrdimensionalen Fouriertransformverfahren angewendet und zwar so dass
- durch Anwendung eines Schichtselektionsgradienten während der Hochfrequenzpulse eine Schicht selektiert wird,
- durch Anwendung eines Lesegradienten, welcher im Sinne eines Gradientenechoverfahrens zunächst eingeschaltet wird und dann in seiner Amplitude umgekehrt wird, ein Gradientenecho gebildet wird.
- vor Auslesen des Gradientenechos eine Phasenkodierung durch Anwendung eines Phasenkodiergradienten senkrecht zum Lesegradienten im Sinne eines zwei-dimensionalen Fourier-Transformverfahrens oder durch Anwendung mehrerer Phasenkodiergradienten in senkrecht aufeinander stehenden Richtungen zur Phasenkodierung im Sinne eines mehrdimensionalen Fourier-Transformverfahrens erfolgt.

Das erfindungsgemäße Verfahren wird also dahingehend erweitert bzw. optimiert, dass zusätzlich zur Änderung der zeitlichen Abfolge aufeinander folgender Phasenkodierschritte (N-Average SSFP Bildgebung) die Datenakquisition mit paralleler Bildgebung erfolgt.

Es ist vorteilhaft, wenn die mit dem Verfahren inhärent verbundene N-fache Messzeitverlängerung durch die Anwendung von paralleler Bildgebung um einen Beschleunigungsfaktor M ganz oder teilweise kompensiert wird.

Der für die parallele Bildgebung gewählte Beschleunigungsfaktor (M) ist unabhängig von der Anzahl der Signalmittelungen (N) und kann demnach so gewählt werden, dass die mit dem N-Average Verfahren inhärent verbundene Messzeitverlängerung ganz oder teilweise wieder kompensiert werden kann.

Die bevorzugte Implementierung weist dabei folgende Merkmale auf:
- Bei N-facher mal identischer Wiederholung jedes Phasenkodierschrittes wird die N-fache Messzeitverlängerung durch Anwendung von paralleler Bildgebung mit einem Beschleunigungsfaktor um einen Faktor M reduziert.
- Im einfachsten Fall wird bei der Verdopplung der einzelnen Phasenkodierschritte (N=2, Double Average SSFP Bildgebung) ein Beschleunigungsfaktor von M=2 gewählt, so dass die Messzeitverlängerung vollständig kompensiert wird, wobei das Signal zu Rausch Verhältnis und die räumliche Auflösung wie bei Standard SSFP Bildgebung erhalten bleiben.

Das Verfahren ist unabhängig von der Wahl der Methode für die parallele Bildgebung und kann mit den bekannten Techniken (SENSE, GRAPPA) kombiniert werden.

### Reduktion von Steady State Storage Artefakten

Das erfindungsgemäße Verfahren lässt sich auch mit beliebigen Phasenkodierschemata sowie mit zeitaufgelöster k-Raum segmentierter Bildgebung kombinieren. Vorzugsweise werden die NMR-Daten mittels k-Raum segmentierter CINE SSFP Bildgebung aufgenommen.

Es ist vorteilhaft, wenn ein nicht-lineares Phasenkodierschema zur k-Raum Abtastung verwendet wird.

Des Weiteren ist es möglich, 'Steady State Storage' Präparation mit SSFP Bildgebung zu kombinieren.

Bei einer vorteilhaften Variante des erfindungsgemäßen Verfahrens erfolgt eine k-Raum Abtastung mit revers zentrischer Phasenkodierung, zur gleichzeitigen Reduktion von Wirbelstrom und 'Steady State Storage' Bildartefakten.

Durch die Wahl geeigneter k-Raum Abtastung können 'Steady State Storage' Artefakte bei gleichzeitiger Vermeidung von Wirbelstromeffekten minimiert werden.

Dabei werden durch 'Steady State Storage' ausgelöste Signaloszillationen durch die Datenaufnahme mit geeigneter zeitlicher Abfolge der Phasenkodierschritte in äußere Bereiche des k-Raums gelegt, so dass daraus resultierende Bildartefakte reduziert werden.

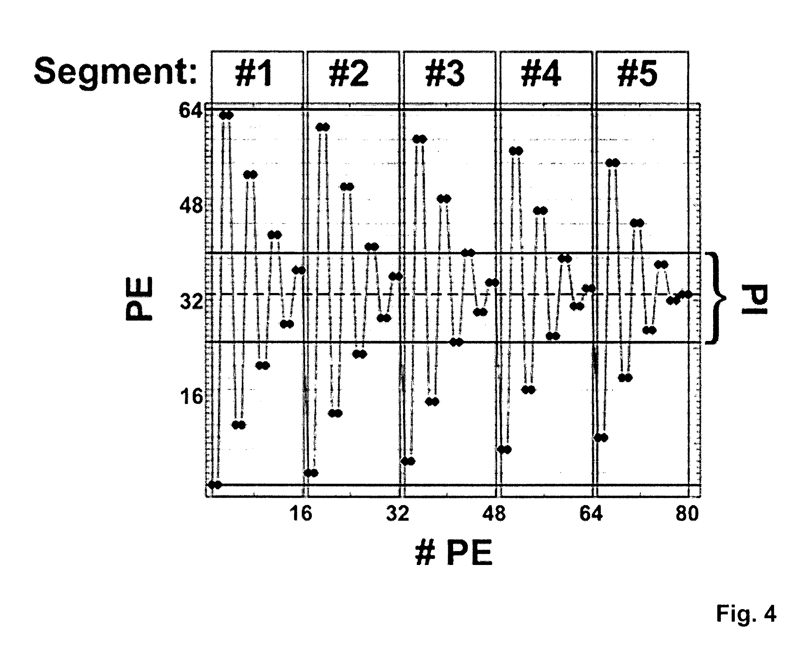

Die Strategie zur Phasenkodierung dafür ist in Fig. 4 für ein revers-zentrisches Phasenkodierschema kombiniert mir paralleler Bildgebung dargestellt (5 Segmente). Potentielle Wirbelstromeffekte als Resultat großer Phasenkodiersprünge werden durch paarweise Akquisition und Signalmittelung (Double Average Bildgebung) für jeden einzelnen Phasenkodierschritt (PE) kompensiert. Für parallele Bildgebung (P1, Ausgleich der durch Double Average bedingten Messzeitverlängerung) werden im zentralen k-Raum Bereich zusätzliche Referenzdaten aufgenommen.

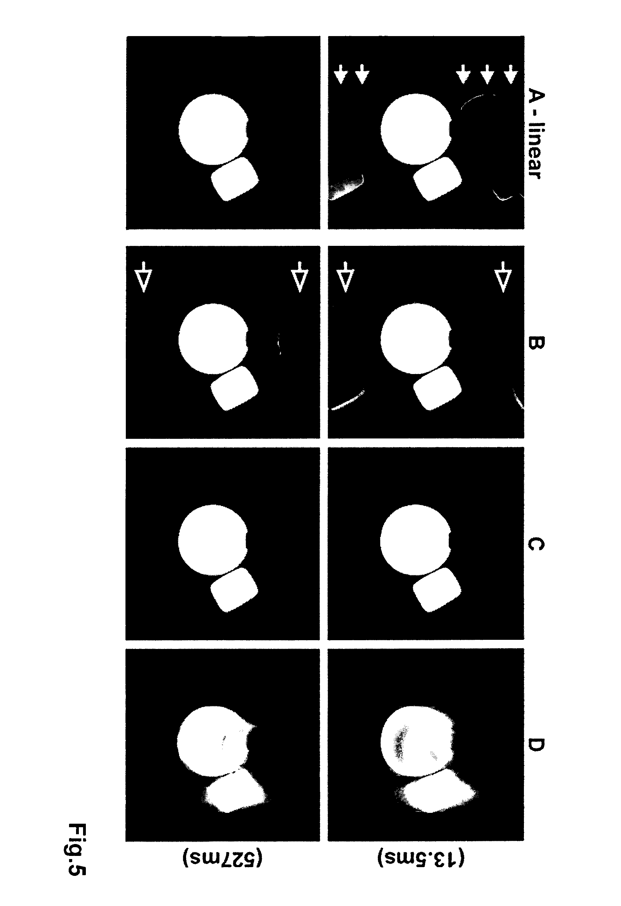

Die Wirkungsweise der Kombination des erfindungsgemäßen Verfahrens mit paralleler Bildgebung, revers-zentrischer k-Raum Abtastung und segmentierter Datenaufnahme sowie ' Steady State Storage ist in Fig. 5 dargestellt.

Im Vergleich zur Datenaufnahme mit Standard (A) und 'Paired Phase Encoding' (B) SSFP Bildgebung resultiert die Anwendung des erfindungsgemäße Verfahren (C) in gleichzeitig reduzierten Wirbelstrom- und 'Steady State Storage' Bildartefakten.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Varianten sind nicht als abschließende Aufzählung zu verstehen, sondern haben vielmehr beispielhaften Charakter für die

Schilderung der Erfindung.

**Fig. 1A** und **Fig. 1B** zeigen eine SSFP Bildgebung am Phantom. Im Vergleich zu linear Phasenkodierung (Fig. 1A) führen Wirbelstromartefakte bei revers zentrischer k-Raum Abtastung (Fig. 1 B) zu Signalfluktuationen und starken Bildartefakten.

**Fig. 2** zeigt ein Schema einer SSFP-Sequenz: HF, GS, GR und GP bezeichnen die Hochfrequenzpulse P1, P2, P3... und Signale S1, S2..., GS den Schichtselektionsgradient, GR den Lesegradient und GP den Phasenkodiergradient.

**Fig. 3A** zeigt ein Verfahren zur idealen Kompensation für Wirbelstromeffekte bei MRT Bildgebung mit SSFP. Die für die MRT Signalerzeugung verantwortlich transversale Komponente des Magnetisierungsvektors (M_{xy}, schwarze Pfeile) wird trotz wirbelstrominduzierter Signalphasen (Δφ_{Eddy}) nach zwei aufeinander folgenden Datenakquisitionsintervallen ((1)->(2) und (3)->(4)) und HF-Anregungen (rf(+α) und rf (-α)) wieder identisch auf sich selbst abgebildet ((4)->(1)). Die duale Konfiguration des SSFP Steady State bleibt erhalten und Artefakte werden vermieden. **Fig. 3B** zeigt die Entstehung von Bildartefakten und Störung der dualen Steady State Konfiguration bei Verwendung inkrementeller Phasenkodierung. Die transversale Komponente des Magnetisierungsvektors (M_{xy}, schwarze Pfeile) wird durch unterschiedliche Phasenkodierschritte und damit verschiedenen wirbelstrominduzierten Signalphasen (Δφ_{Eddy,I} und Δφ_{Eddy,II}) nach zwei Datenakquisitionsintervallen ((1)->(2) und (3)->(4)) und HF-Anregungen (rf(+α) und rf (-α)) nicht wieder auf sich selbst abgebildet ((4)->(1') statt (1)). Die duale Konfiguration des SSFP Steady State wird dadurch gestört und es kommt zu Signalfluktuationen und Bildartefakten.

**Fig. 4** veranschaulicht die Strategie zur Phasenkodierung mit dem erfindungsgemäßen Verfahren am Beispiel von k-Raum segmentierter (5 Segmente) Datenaufnahme mit einer revers-zentrischen Trajektorie und kombiniert mit paralleler Bildgebung. Potentielle Wirbelstromeffekte als Resultat großer Phasenkodiersprünge werden durch paarweise Akquisition und Signalmittelung (Double Average Bildgebung) für jeden einzelnen Phasenkodierschritt (PE) kompensiert. Für parallele Bildgebung (P1, Ausgleich der durch Double Average bedingten Messzeitverlängerung) werden im zentralen k-Raum Bereich zusätzliche Referenzdaten aufgenommen.

**Fig. 5** zeigt eine k-Raum segmentierte CINE SSFP Bildgebung am Phantom mit linearer (A) und revers zentrischer k-Raum Abtastung (B-D) direkt nach 'Steady State Storage' (obere Reihe) sowie zu einem späteren Zeitpunkt (untere Reihe). Im Vergleich zur Datenaufnahme mit Standard (A) und 'Paired Phase Encoding' SSFP Bildgebung resultiert die Anwendung des erfindungsgemäße Verfahren (C) in deutlich reduzierten Bildartefakten. Als Referenz (D) sind auch starke Wirbelstromartefakte in Bildern mit revers zentrischer k-Raum Abtastung aber ohne Wirbelstromkompensation (d.h. inkrementeller Phasenkodierung) gezeigt.

### LITERATURLISTE

[1] Carr HY. Steady-State Free Precession in Nuclear Magnetic Resonance. Physical Review 1958;112(5):1693-1701.
[2] Oppelt A, Graumann R, Barfuß H, Fischer H, Hartl W, Schajor W. FISP―a new fast MRI sequence. Electromedica (Engl Ed) 1986;54(54):15-18.
[3] Scheffler K, Lehnhardt S. Principles and applications of balanced SSFP techniques. Eur Radiol 2003;13(11):2409-2418.
[4] Foxall DL. Frequency-modulated steady-state free precession imaging. Magn Reson Med 2002;48(3):502-508.
[5] Bieri O, Scheffler K, In Proc. Intl. 12th Scientific Meeting International Society of Magnetic Resonance in Medicine, Kyotzo, Japan, 2004, Nr. 104
[6] Pruessmann KP, Weiger M, Scheidegger MB, Boesiger P. SENSE: sensitivity encoding for fast MRI. Magn Reson Med 1999;42(5):952-962.
[7] Griswold MA, Jakob PM, Heidemann RM, Nittka M, Jellus V, Wang J, Kiefer B, Haase A. Generalized autocalibrating partially parallel acquisitions (GRAPPA). Magn Reson Med 2002;47(6):1202-1210.
[8] Scheffler K, Heid O, Hennig J. Magnetization preparation during the steady state: fat-saturated 3D TrueFISP. Magn Reson Med 2001;45(6):1075-1080.

## Patentansprüche

1. Verfahren nach der Technik eines Steady State Free Precession (SSFP) - Gradientenecho-Verfahrens, insbesondere der Kernspin(=NMR)tomographie, bei welchem eine regelmäßige Folge von Hochfrequenzpulsen mit Flipwinkel α im zeitlich konstanten Abstand TR angewendet wird, wobei die Phase dieser Pulse in aufeinander folgenden Schritten um ein konstantes Phaseninkrement erhöht wird.
**dadurch gekennzeichnet,**
**dass** ein vorgegebenes Phasenkodierschema so durchgeführt wird, dass jeder einzelne Phasenkodierschritt N mal identisch wiederholt wird und dabei folgende Bedingungen gelten:
- N geradzahlig und N ≥ 2, also (N=2, 4, 6, 8,...);
- aufeinander folgende gemessene NMR-Signale werden gemittelt.

2. Verfahren nach Anspruch 1, **dadurch gekennzeichnet, dass** zusätzlich zu der Folge von Hochfrequenzpulsen Magnetfeldgradienten zur Kodierung eines NMR-Bildes entsprechend einem zwei- oder auch mehrdimensionalen Fouriertransformverfahren angewendet werden und zwar so dass
- durch Anwendung eines Schichtselektionsgradienten während der Hochfrequenzpulse eine Schicht selektiert wird,
- durch Anwendung eines Lesegradienten, welcher im Sinne eines Gradientenechoverfahrens zunächst eingeschaltet wird und dann in seiner Amplitude umgekehrt wird, ein Gradientenecho gebildet wird.
- vor Auslesen des Gradientenechos eine Phasenkodierung durch Anwendung eines Phasenkodiergradienten senkrecht zum Lesegradienten im Sinne eines zwei-dimensionalen Fourier-Transformverfahrens oder durch Anwendung mehrerer Phasenkodiergradienten in senkrecht aufeinander stehenden Richtungen zur Phasenkodierung im Sinne eines mehrdimensionalen Fourier-Transformverfahrens erfolgt.

3. Verfahren nach Anspruch 1 oder 2, **dadurch gekennzeichnet, dass** die mit dem Verfahren inhärent verbundene N-fache Messzeitverlängerung durch die Anwendung von paralleler Bildgebung um einen Beschleunigungsfaktor M ganz oder teilweise kompensiert wird.

4. Verfahren nach einem der vorhergehenden Ansprüche, **dadurch gekennzeichnet, dass** ein nicht-lineares Phasenkodierschema zur k-Raum Abtastung verwendet wird

5. Verfahren nach einem der vorhergehenden Ansprüche, **dadurch gekennzeichnet, dass** die NMR-Daten mittels k-Raum segmentierter CINE SSFP Bildgebung aufgenommen werden.

6. Verfahren nach einem der vorhergehenden Ansprüche, **dadurch gekennzeichnet, dass** 'Steady State Storage' Präparation mit SSFP Bildgebung kombiniert wird.

7. Verfahren nach einem der vorhergehenden Ansprüche, **dadurch gekennzeichnet, dass** eine k-Raum Abtastung mit revers zentrischer Phasenkodierung, zur gleichzeitigen Reduktion von Wirbelstrom und 'Steady State Storage' Bildartefakten, erfolgt.

8. Verfahren nach einem der vorhergehenden Ansprüche, **dadurch gekennzeichnet, dass** eine Anwendung von Magnetfeldgradienten entsprechend einer Bildkodierung nach dem Verfahren der gefilterten Rückprojektion erfolgt.
